# EUROPÄISCHE PATENTSCHRIFT

(11) **EP 3 898 181 B1**
(45) Veröffentlichungstag und Bekanntmachung des Hinweises auf die Patenterteilung: **01.01.2025**
(21) Anmeldenummer: 19797585.7
(22) Anmeldetag: 21.10.2019
(51) Int. Cl.: B29C 64/124, B33Y 70/00, B33Y 30/00, B33Y 10/00, B29C 64/277, B29C 64/273, G03F 7/00, G03F 7/031, G03F 7/095, G03F 7/20

(54) **PARALLELISIERTE 3D-LITHOGRAPHIE MITTELS MEHRSTRAHLIGER, MEHRFARBIGER LICHTINDUZIERTER POLYMERISATION**
PARALLELISED 3D LITHOGRAPHY USING MUTI-BEAM, MULTI-COLOUR LIGHT-INDUCED POLYMERISATION
LITHOGRAPHIE 3D PARALLÉLISÉE PAR POLYMÉRISATION INDUITE PAR LA LUMIÈRE MULTICOLORE ET MULTIFAISCEAUX

(30) Priorität: 17.12.2018 DE 102018009916
(43) Veröffentlichungstag der Anmeldung: 27.10.2021
(73) Patentinhaber: Karlsruher Institut für Technologie, 76131 Karlsruhe (DE)
(72) Erfinder: HAHN, Vincent, 76131 Karlsruhe (DE); MÜLLER, Patrick, 76149 Karlsruhe (DE); BLASCO, Eva, 76227 Karlsruhe (DE); WEGENER, Martin, 76227 Karlsruhe (DE)
(74) Vertreter: Müller-Boré & Partner Patentanwälte PartG mbB
(86) Internationale Anmeldenummer: PCT/EP2019/078557
(87) Internationale Veröffentlichungsnummer: WO 2020/126154

(56) Entgegenhaltungen:
- EP-A1- 3 208 075
- WO-A1-2006/109355
- WO-A1-2017/104368
- US-A- 4 041 476
- US-A1- 2003 013 047
- US-A1- 2016 067 921
- JIANG ET AL: "Development of a novel two-laser beam stereolithography system", RAPID PROTOTYPING JOURNAL, MCB UNIVERSITY PRESS, BRADFORD, GB, vol. 17, no. 2, 8 March 2011 (2011-03-08), pages 148 - 155, XP009535495, ISSN: 1355-2546, DOI: 10.1108/13552541111113899

## Beschreibung

Die vorliegende Erfindung betrifft ein Verfahren zur additiven Herstellung einer 3D-strukturierten Form und eine Vorrichtung zur additiven Herstellung einer 3D-strukturierten Form.

Eine gängige Variante für die Herstellung 3D-gedruckter Formen ist die lichtinduzierte Polymerisation (Photopolymerisation). Ein flüssiger Photolack wird dabei durch die Bestrahlung mit Licht ausgehärtet. Unbelichtete Bereiche bleiben flüssig und werden während eines Entwicklungsschrittes ausgewaschen.

US 4 041 476 A offenbart ein Verfahren, eine Vorrichtung und ein Produkt, bei dem eine dreidimensionale Figur in situ in einem Medium mit zwei aktiven Komponenten geformt wird, indem zwei Strahlen in dem Medium zur Kreuzung gebracht werden. Die unterschiedlichen Komponenten werden so ausgewählt, dass sie auf das gleichzeitige Vorhandensein des Strahls ansprechen und entweder reagieren oder Reaktanten erzeugen, die den Schnittpunkt der Strahlen physikalisch spürbar oder unterscheidbar machen.

Die Grundvoraussetzung, um 3D-strukturierte Formen herzustellen, ist dabei, dass der Photolack räumlich selektiv ausgehärtet werden kann. Dafür haben sich mehrere Lösungen etabliert. Für Strukturgrößen im Mikrometerbereich wird beispielsweise die Zwei-Photonen-Lithographie eingesetzt. Bei dieser Lithographiemethode wird ein langwelliger Laser hoher Leistung in den flüssigen Photolack fokussiert. Da der Photolack größtenteils transparent für den Laser ist, kommt es nur direkt im Fokus zu einer Polymerisation. Dort werden Intensitäten erreicht, die groß genug sind, um mittels Zwei-Photonen-Absorption den Photolack auszuhärten. Diese hohen Intensitäten werden typischerweise mit Ultrakurzpuls-Lasern erreicht. Um ganze Volumina zu belichten, wird der fokussierte Laser im flüssigen Photolack gerastert.

Ein Nachteil dieser Methode ist die fehlende Parallelisierung. Einzelne Bildpunkte werden seriell belichtet. Dies hat hauptsächlich zwei Gründe: Werden mehrere Laserfokusse eng beieinander erzeugt, wie es für eine Parallelisierung notwendig ist, kommt es auch jenseits der Fokusebene zu einer Überlagerung benachbarter Laserstrahlen. Auch dort werden Intensitäten erreicht, die ausreichend sind, um den Photolack auszuhärten. Dadurch geht die notwendige räumliche Selektivität für die Herstellung einer strukturierten Form in einem 3D-Druckprozess verloren. Des Weiteren werden die Leistungsanforderungen an den Laser so groß, dass diese nur noch mit einem hohen technischen Aufwand erreicht werden können.

Der vorliegenden Erfindung liegt daher die Aufgabe zugrunde, ein Verfahren und eine Vorrichtung bereitzustellen, die einen parallelisierten 3D-Druck für Strukturgrößen im Mikrometerbereich, ausgehend von einem flüssigen Photolack, ermöglichen.

Anspruch 1 definiert das Verfahren gemäß der Erfindung und Anspruch 6 definiert die Vorrichtung gemäß der Erfindung.

Ein erster Aspekt der Erfindung betrifft ein Verfahren zur additiven Herstellung einer 3D-strukturierten Form, umfassend die Schritte in der folgenden Reihenfolge:
i) Bereitstellen eines flüssigen Photolacks, umfassend mindestens ein Monomer und mindestens ein Photoinitiatorsystem,
ii) Bestrahlen des flüssigen Photolacks mit einer ersten Lichtquelle bei einer ersten Wellenlänge λ₁ und mit einer zweiten Lichtquelle bei einer zweiten Wellenlänge λ₂, wobei λ₁ ≠ λ₂ und
   eine Aushärtung des flüssigen Photolacks zu der 3D-strukturierten Form nur an der Position erfolgt, die von der ersten Lichtquelle und der zweiten Lichtquelle mit einem zeitlichen Abstand von kleiner als 1 ms bestrahlt wird.

Die vorliegende Erfindung ermöglicht eine vorteilhafte parallelisierte Herstellung einer 3D-strukturierten Form, da die Aushärtung des Photolacks nur an der Position erfolgt, die von der ersten Lichtquelle und der zweiten Lichtquelle mit einem zeitlichen Abstand von kleiner als 1 ms bestrahlt wird. Bevorzugt entspricht diese Position der Fokusebene von mindestens einer aus der ersten Lichtquelle und der zweiten Lichtquelle.

Gemäß der vorliegenden Erfindung erfolgt die Aushärtung des flüssigen Photolacks zu der 3D-strukturierten Form nur an der Position, die von der ersten Lichtquelle und der zweiten Lichtquelle mit einem zeitlichen Abstand von kleiner als 1 ms bestrahlt wird. In einer Ausführungsform bestrahlen die erste Lichtquelle und die zweite Lichtquelle den flüssigen Photolack sequenziell mit einem zeitlichen Abstand von kleiner als 1 ms, bevorzugt kleiner als 1 µs. In einer weiteren Ausführungsform bestrahlen die erste Lichtquelle und die zweite Lichtquelle den flüssigen Photolack gleichzeitig.

Erfindungsgemäß ist unter einem "Verfahren zur additiven Herstellung" (d.h. "additives Verfahren") ein Verfahren zu verstehen, bei dem die 3D-strukturierte Form durch Aushärtung des flüssigen Photolacks schrittweise aufgebaut wird. Das erfindungsgemäße Verfahren zur additiven Herstellung ist zu unterscheiden von einem Verfahren zur subtraktiven Herstellung (d.h. "subtraktives Verfahren"), bei dem Material einer Form abgetragen wird.

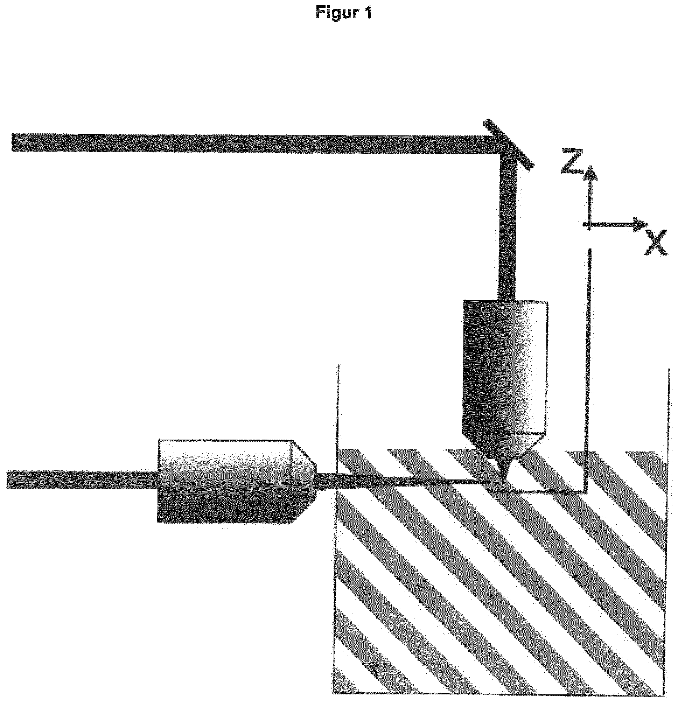

Eine Ausführungsform des Verfahrens zur additiven Herstellung gemäß der vorliegenden Erfindung ist in Figur 1 gezeigt. Der als grau gestreifte Fläche dargestellte flüssige Photolack wird mit einer ersten Lichtquelle bei einer ersten Wellenlänge λ₁ und mit einer zweiten Lichtquelle bei einer zweiten Wellenlänge λ₂ bestrahlt.

Die 3D-strukturierte Form gemäß der vorliegenden Erfindung ist nicht besonders eingeschränkt. Dadurch dass die Aushärtung des Photolacks nur an der Position erfolgt, die von der ersten Lichtquelle und von der zweiten Lichtquelle mit einem zeitlichen Abstand von kleiner als 1 ms bestrahlt wird, können Strukturierungen von kleiner als 10 µm, bevorzugt kleiner als 1 µm, erzeugt werden. Die minimal erreichbare Strukturgröße ist nicht besonders eingeschränkt. In einer Ausführungsform weist die Strukturierung eine Größe von mindestens einem Zehntel der Wellenlänge der verwendeten Lichtquellen auf.

Die 3D-strukturierte Form kann beispielsweise eine Prothese, ein Zelltemplat mit kontrollierter Mikrostrukturierung oder ein Metamaterial sein oder in der Mikrooptik und Mikrofluidik eingesetzt werden.

Der Schritt i) des Bereitstellens des flüssigen Photolacks, umfassend mindestens ein Monomer und mindestens ein Photoinitiatorsystem, gemäß der vorliegenden Erfindung ist nicht besonders eingeschränkt.

In einer Ausführungsform wird der flüssige Photolack in dem Schritt i) in einem Behälter bereitgestellt. Gemäß einer Ausführungsform ist der Behälter ein Glasgefäß oder ein Kunststoffgefäß, das optisch transparent für die verwendeten Wellenlängen ist. Alternativ kann ein nichttransparenter Behälter verwendet werden, der über passende Öffnungen für Abbildungslinsen verfügt. Gemäß einer Ausführungsform schließt der Behälter ein Volumen ein, das größer als die zu druckende 3D-strukturierte Form oder ein Teilstück dieser ist. Gemäß einer Ausführungsform der vorliegenden Erfindung befindet sich in dem Behälter ein Substrat, das die hergestellte 3D-strukturierte Form stützt.

In einer weiteren Ausführungsform kann der flüssige Photolack ohne Behälter direkt auf dem Substrat bereitgestellt werden. Diese Ausführungsform kann beispielsweise eingesetzt werden, wenn nicht erfindungsgemäß die Bestrahlungsrichtung der ersten Lichtquelle gleich der Bestrahlungsrichtung der zweiten Lichtquelle ist. Dabei kann das Substrat in dieser Ausführungsform eine transparente Fläche sein.

Bevorzugt ist das Substrat eine Bühne oder auf einer Bühne angebracht, die mindestens entlang der z-Achse in axiale Richtung bewegt werden kann. Die z-Achse ist die Achse, die senkrecht zu den Schichten verläuft, die in dem Verfahren zur additiven Herstellung in einer Ausführungsform aufgebaut werden. Gemäß einer weiteren Ausführungsform ist die Bühne in Richtung der x-, y- und z-Achse beweglich. Durch die zusätzliche Beweglichkeit der Bühne in x- und y-Richtung lateral können auch große Strukturen hergestellt werden, da das lateral limitierte Bildfeld handelsüblicher Linsen überwunden werden kann.

Gemäß einer bevorzugten Ausführungsform wird die 3D-strukturierte Form schichtweise entlang der z-Achse aufgebaut. Dabei wird bevorzugt die Bühne in z-Richtung bewegt.

In der vorliegenden Erfindung sind die erste Lichtquelle mit der ersten Wellenlänge λ₁ und die zweite Lichtquelle mit der zweiten Wellenlänge λ₂ nicht besonders eingeschränkt, solange λ₁ ≠ λ₂ ist. Bevorzugt ist die Wellenlänge der ersten Lichtquelle und der zweiten Lichtquelle jeweils in einem Bereich zwischen 190 nm und 900 nm. Beispielsweise kann als Lichtquelle ein Laser oder eine Leuchtdiode verwendet werden. Bevorzugt wird als erste Lichtquelle und zweite Lichtquelle eine Lichtquelle mit einer Wellenlänge im UV/VIS- oder Infrarot-Bereich verwendet. Weiter bevorzugt wird ein Laser als erste Lichtquelle und als zweite Lichtquelle verwendet. Die erste Wellenlänge λ₁ und die zweite Wellenlänge λ₂ sind abhängig von der Wahl des Photoinitiatorsystems.

Gemäß einer weiteren Ausführungsform sind die erste Lichtquelle und die zweite Lichtquelle Laser, wobei mindestens einer der Laser ein gepulster Laser ist. In der vorliegenden Erfindung ist unter einem "gepulsten Laser" ein Laser zu verstehen, der Strahlung in zeitlich diskreten Pulsen emittiert. Falls kein gepulster Laser als Laser verwendet wird, ist der Laser ein Dauerstrichlaser. Ein "Dauerstrichlaser" ist ein kontinuierlich angeregter Laser. In einer Ausführungsform sind beide Lichtquellen gepulste Laser. Die Pulsdauer, Pulswiederholrate, Bestrahlungsdauer und Bestrahlungsleistung sind dabei nicht besonders eingeschränkt und können passend zu den Lebensdauern der Zustände des Photoinitiatorsystems gewählt werden. Durch die Verwendung eines passend gepulsten Lasers kann eine räumlich selektive Aushärtung deshalb besonders leicht erreicht werden.

Die Anordnung der ersten Lichtquelle und der zweiten Lichtquelle zueinander ist gemäß der vorliegenden Erfindung nicht besonders eingeschränkt, solange die erste Lichtquelle und die zweite Lichtquelle den Photolack bestrahlen können, so dass an der Position der Bestrahlung durch die erste Lichtquelle und die zweite Lichtquelle mit einem zeitlichen Abstand von kleiner als 1 ms der Photolack aushärtet. Die Bestrahlungsrichtung der ersten Lichtquelle und der zweiten Lichtquelle ist erfindungsgemäß unterschiedlich.

In einer nicht erfindungsgemäßen Ausführungsform ist die Bestrahlungsrichtung der ersten Lichtquelle gleich der Bestrahlungsrichtung der zweiten Lichtquelle. Eine Vorrichtung mit einer solchen Ausrichtung der ersten Lichtquelle und der zweiten Lichtquelle kann ohne großen apparativen Aufwand realisiert werden.

Erfindungsgemäß ist die Bestrahlungsrichtung der ersten Lichtquelle verschieden von der Bestrahlungsrichtung der zweiten Lichtquelle. Durch diese unterschiedliche räumliche Anordnung der ersten Lichtquelle und der zweiten Lichtquelle kann besonders leicht die räumliche Selektivität der Aushärtung des Photolacks erreicht werden.

Gemäß einer Ausführungsform der vorliegenden Erfindung weist die Bestrahlungsrichtung der ersten Lichtquelle zu der Bestrahlungsrichtung der zweiten Lichtquelle bezüglich der Fokusebene der beiden Lichtquellen einen Winkel in einem Bereich von 45° bis 135°, bevorzugt von 60° bis 120°, besonders bevorzugt von 80° bis 100°, auf. Durch einen solchen Winkel kann eine besonders vorteilhafte räumliche Selektivität der Aushärtung des Photolacks erreicht werden.

Einer Ausführungsform des erfindungsgemäßen Verfahrens entsprechend wird im Schritt ii) die herzustellende 3D-strukturierte Form in mindestens eine der Fokusebenen der ersten Lichtquelle und der zweiten Lichtquelle abgebildet. Dabei können beispielsweise Mikrospiegelaktoren verwendet werden. Diese Mikrospiegelaktoren haben kurze Schaltzeiten von nur einigen Mikrosekunden. Dadurch kann eine einzelne Ebene im Photolack innerhalb von Mikrosekunden belichtet werden. Alternativ können Flüssigkristallanzeigen abgebildet werden. Diese besitzen Schaltzeiten von einigen Millisekunden.

Der flüssige Photolack gemäß der vorliegenden Erfindung ist nicht besonders eingeschränkt, solange er mindestens ein Monomer und mindestens ein Photoinitiatorsystem umfasst und in einem flüssigen Zustand vorliegt.

In einer Ausführungsform umfasst der Photolack von 70 Gew.-% bis 99,99 Gew.-%, bevorzugt von 85 Gew.-% bis 99,5 Gew.-%, besonders bevorzugt von 95 Gew.-% bis 99 Gew.-%, des mindestens einen Monomers und von 0,01 Gew.-% bis 30 Gew.-%, bevorzugt von 0,5 Gew.-% bis 15 Gew.-%, besonders bevorzugt von 1 Gew.-% bis 5 Gew.-%, des mindestens einen Photoinitiatorsystems. Das Monomer und/oder das Photoinitiatorsystem können auch in einem Lösemittel gelöst vorliegen, wobei dann jeweils die Kombination aus Monomer und Lösemittel und Photoinitiatorsystem und Lösemittel den obengenannten Gewichtsteilen entsprechen. Die Wahl des Lösemittels ist nicht besonders eingeschränkt. Bevorzugt ist ein wenig flüchtiges und wenig giftiges Lösemittel, zum Beispiel Dimethylsulfoxid, Anisol oder 2-Propanol.

Das in der vorliegenden Erfindung verwendete mindestens eine Monomer ist nicht besonders eingeschränkt, solange es durch Photopolymerisation aushärtbar ist. Das Monomer kann monofunktionell oder multifunktionell sein. Dabei kann "multifunktionell" bifunktionell, trifunktionell oder eine höhere Funktionalität als trifunktionell bedeuten. In der vorliegenden Erfindung kann ein Monomer mit nur einer Art von Funktionalität oder ein Gemisch von Monomeren verschiedener Funktionalitäten verwendet werden. Bevorzugt wird mindestens ein multifunktionelles Monomer verwendet.

Das eine Monomer kann mindestens ein Bestandteil der Gruppe, bestehend aus Vinylpyrrolidon, Acrylnitril, (Meth)acrylsäure, Vinylacetat, Methyl(meth)acrylat, Ethylacrylat, (Iso)Butylvinylether, Vinylbutyrat, Methylacrylamid, Isopropylacrylamid, Tricyclo[5.2.1.0^{2,6}]decandimethanoldi(meth)acrylat, Polyethylenglykoldi(meth)acrylat, Bisphenol A-Ethoxyaldi(meth)acrylat, Bis(acrylamid), Pentaerythritoltri(meth)acrylat, Trimethylolpropantri(meth)acrylat, Trimethylolpropanpropoxylattri(meth)acrylat, Trimethylolpropanethoxylattri(meth)acrylat, Glycerolpropoxylattri(meth)acrylat, Di(trimethylolpropan)tetra(meth)acrylat, Pentaerythritoltetra(meth)acrylat und Dipentaerythritol(penta-/hexa)-(meth)acrylat, sein.

Das mindestens eine Photoinitiatorsystem gemäß der vorliegenden Erfindung ist nicht besonders eingeschränkt. Erfindungsgemäß wird unter dem Begriff "Photoinitiatorsystem" ein System verstanden, das erst durch das Bestrahlen mit der ersten Lichtquelle bei einer ersten Wellenlänge λ₁ und mit der zweiten Lichtquelle bei einer zweiten Wellenlänge λ₂ mit einem zeitlichen Abstand von kleiner als 1 ms ein Radikal bildet, das die Polymerisation des mindestens einen Monomers des flüssigen Photolacks starten kann. Das Photoinitiatorsystem umfasst mindestens einen Photoinitiator. Dieser kann direkt als Verbindung in dem Photoinitiatorsystem vorliegen oder durch Edukte *in situ* synthetisiert werden. In der vorliegenden Erfindung ist unter einem "Photoinitiator" eine Verbindung zu verstehen, die nach Absorption von Strahlung ein Radikal bildet, das die Aushärtung des Photolacks ermöglicht.

Das Photoinitiatorsystem geht nach der Absorption eines ersten Photons mit der ersten Wellenlänge λ₁ der ersten Lichtquelle in einen "dormanten Zwischenzustand" über. Dieser Zwischenzustand besitzt keine aushärtende Eigenschaft. In Folge der Absorption eines zweites Photon mit der zweiten Wellenlänge λ₂ ≠ λ₁ der zweiten Lichtquelle wird in dem Photoinitiatorsystem ein Radikal gebildet, das das mindestens eine Monomer aushärten kann. Dabei kann das erste Photon der Wellenlänge λ₁ und das zweite Photon der Wellenlänge λ₂ von nur einem Bestandteil des Photoinitiatorsystems oder von unterschiedlichen Bestandteilen des Photoinitiatorsystems absorbiert werden.

Die Bestandteile des Photoinitiatorsystems sind nicht besonders eingeschränkt, solange mindestens ein Photoinitiator umfasst ist. Weiterhin kann das Photoinitiatorsystem mindestens einen Bestandteil aus einem Photosensibilisator und einem Photosäuregenerator umfassen. Erfindungsgemäß wird unter einem "Photosensibilisator" eine Verbindung verstanden, die bei einer lichtinduzierten Reaktion als Energieträger oder Radikalbildner für einen Photoinitiator wirkt.

Erfindungsgemäß kehrt der dormante Zwischenzustand wieder in den Grundzustand zurück, falls kein zweites Photon der zweiten Wellenlänge λ₂ von dem Photoinitiatorsystem absorbiert wird. In einer Ausführungsform beträgt die Dauer der Rückkehr in den Grundzustand weniger als 1 s und, weiter bevorzugt, weniger als 1 ms. Aufgrund dieser kurzen Dauer der Rückkehr in den Grundzustand kann besonders vorteilhaft die selektive räumliche Aushärtung des Photolacks erreicht und schnelle Druckvorgänge ermöglicht werden.

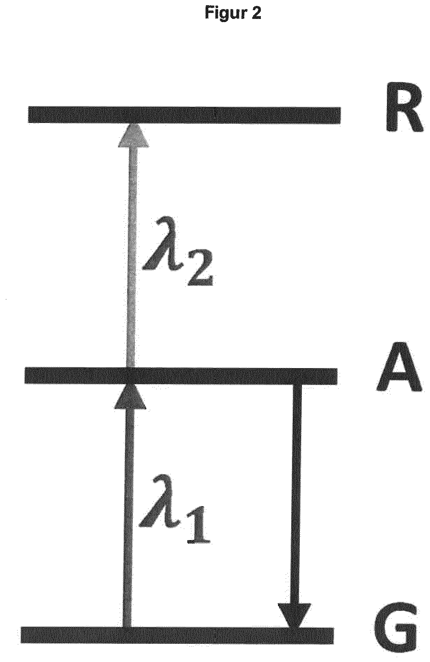

Eine schemenhafte Darstellung der Energieniveaus des Photoinitiatorsystems ist in Figur 2 gezeigt. Der dormante Zwischenzustand ist mit "A" und der aushärtende Zustand ist mit "R" gekennzeichnet.

In einer Ausführungsform weist der dormante Zwischenzustand höchstens eine geringe Absorption eines Photons der ersten Wellenlänge λ₁ auf. Bevorzugt weist der dormante Zwischenzustand keine Absorption eines Photons der ersten Wellenlänge λ₁ auf. Dadurch kann die räumliche Selektivität der Aushärtung des Photolacks verbessert werden.

Die Bereitstellung des Photoinitiatorsystems, das den Photolack aushärtet, gemäß der vorliegenden Erfindung ist nicht besonders eingeschränkt. Dabei kann in einer Ausführungsform mindestens ein Bestandteil verwendet werden, der sowohl das erste Photon der Wellenlänge λ₁ und das zweite Photon der Wellenlänge λ₂ absorbiert. In einer weiteren Ausführungsform können mindestens zwei Bestandteile verwendet werden, wobei mindestens ein Bestandteil das erste Photon der Wellenlänge λ₁ und mindestens ein weiterer Bestandteil das zweite Photon der Wellenlänge λ₂ absorbiert.

Dabei können, abhängig von den Bestandteilen des Photoinitiatorsystems, verschiedene Mechanismen verwendet werden.

Gemäß einer Ausführungsform umfasst das Photoinitiatorsystem mindestens eines aus 1) einer Verbindung mit einer hohen Bindungsbruchenergie, 2) einer Verbindung mit einer photolabilen Schutzgruppe, 3) einem *in-situ* photosynthetisierten Initiator, 4) einer photochromischen Verbindung, 5) einem Quencher und 6) einem pH-sensitiven Photoinitiator.
1) Verbindung mit hoher Bindungsbruchenergie

Typische Photoinitiatoren funktionieren, indem ein Photoinitiatormolekül ein Photon absorbiert, um vom Grundzustand (S₀) in den einen angeregten Singulett-Zustand (Sᵢ) überzugehen. Durch "Interkombination" (engl.: "intersystem crossing") kann das Molekül in den Triplett-Zustand (Tᵢ) übergehen. Ausgehend von einem dieser beiden Zustände (Sᵢ oder Tᵢ) kommt es bei Photoinitiatoren durch Bindungsspaltung (Norrish-Reaktion vom Typ I) oder durch Wasserstoffabspaltung (Norrish-Reaktion vom Typ II) zur Radikalbildung.

Die Bindungsspaltung gemäß Norrish-Reaktion Typ I oder II kann nur stattfinden, wenn die dafür notwendige Energie deutlich geringer als die Zustandsenergie der Verbindung ist. Ist dies nicht der Fall, sind eine Bindungsspaltung und die damit einhergehende Radikalbildung äußerst unwahrscheinlich. Im Folgenden werden Beispiele für Bestandteile eines erfindungsgemäßen Photoinitiatorsystems genannt, die eine Bindungsspaltung gemäß Norrish-Reaktion Typ I oder II eingehen.

In einer Ausführungsform umfasst das Photoinitiatorsystem nach dem obengenannten Mechanismus 1) mindestens einen Bestandteil einer Gruppe, bestehend aus einem α-Diketon, einem Naphthylester, Carbazol, einem Oligothiophen, einem p-Phenylbenzoylderivat, einem Phenylphenacylderivat und Phenothiazin.

Beispiele für α-Diketone, die in der vorliegenden Erfindung verwendet werden können, sind Benzil, Diacetyl und Campherchinon.

Benzil geht eine Norrish-Reaktion vom Typ I ein, nachdem das Molekül in einen höheren Triplett-Zustand (Tₙ) angeregt wurde. Diese Anregung kann stufenweise erfolgen, wenn Benzil zunächst optisch in den Triplett-Grundzustand (T₁) angeregt wird. Diese Anregung kann mit einer Wellenlänge < 440 nm erreicht werden. Der T₁-Zustand besitzt eine Absorptionsbande mit Maximum bei einer Wellenlänge von 480 nm. Aus diesem Zustand können Radikale gebildet werden.

Diacetyl absorbiert im Grundzustand Licht der Wellenlänge < 500 nm. Im Gegensatz zu Benzil besitzt Diacetyl die T₁-Tₙ-Absorptionsbande jedoch mit Absorptionsmaximum im Nahinfrarot-Bereich (> 600 nm). Vorteilhaft ist, dass sich die Absorptionsspektren der S₀-Sᵢ- und T₁-Tₙ-Übergänge kaum überlappen. Allerdings findet bei Diacetyl im T₁-Zustand bereits eine Wasserstoffabspaltung statt, wodurch der T₁-Zustand verarmt. Dem kann mit einer ausreichend hohen Intensität der Nahinfrarot-Strahlungsquelle begegnet werden, wodurch der T₁-Tₙ-Übergang induziert wird.

Campherchinon verhält sich ähnlich wie Diacetyl.

Für einige Naphthylester liegt das Energieniveau des Triplett-Grundzustands T₁ bei etwa 250 kJ/mol. Solche Naphthylester sind beispielsweise Phenyl-1-Naphthoat, Phenyl-2-Naphthoat, Methyl-1-Naphthoat, Methyl-2-Naphthoat, Naphthalen-1-ylbenzoat, Naphthalen-2-ylbenzoat, Naphthalen-1-ylacetat und Naphthalen-2-ylacetat. Die für eine Bindungsspaltung notwendige Energie beträgt, abhängig von der genauen Molekülkonfiguration, etwa 200 kJ/mol. Dennoch ist eine Bindungsspaltung aus dem T₁-Zustand nicht zu beobachten. Die Tatsache, dass es zu keinem Bindungsbruch aus dem T₁-Zustand kommt, ist durch große Energiebarrieren zwischen dem T₁-Zustand und dem Zustand der dissoziierten Bindung begründet. Eine Bindungsspaltung und eine damit einhergehende Radikalbildung kann aus höher angeregten Triplett-Zuständen beobachtet werden.

Die Naphthylester-Moleküle können beispielsweise indirekt in den T₁-Zustand überführt werden, indem Benzophenon als Photosensibilisator bei 365 nm angeregt wird. Benzophenon geht nach einer optischen Anregung mit sehr hoher Wahrscheinlichkeit *via* Interkombination in den T₁-Zustand über und kann andere Moleküle mittels eines Energietransfers in einen Triplett-Zustand überführen. Die T₁-Naphthylester können optisch bei etwa 430 nm angeregt und in höher angeregte Triplett-Zustände überführt werden.

Carbazol bildet nach einer schrittweisen Absorption zweier Photonen unterschiedlicher Wellenlänge ein Carbazyl-Radikal. Das Radikal wird bei Carbazol aus einem angeregten Singulett-Zustand gebildet. Dies steht im Gegensatz zu den zuvor genannten Molekülen, die Radikale aus dem Triplett-Zustand generieren. Carbazol kann mit einer Wellenlänge < 365 nm in den ersten angeregten Singulett-Zustand überführt werden. Von dort kann eine weitere Anregung in höher angeregte Singulett-Zustände optisch mit einer Wellenlänge > 500 nm erfolgen.

Ein Beispiel für ein Oligothiophen, das die obengenannten Eigenschaften aufweist, ist α-Quinquethiophen. Dieses kann schrittweise durch Bestrahlung mit der ersten Lichtquelle und mit der zweiten Lichtquelle in höhere Triplett-Zustände (Tₙ) angeregt werden, wobei es von diesen Zuständen in Radikale zerfällt. Dabei kann beispielsweise ein erster Laser mit einer Wellenlänge von 420 nm und ein zweiter Laser mit einer Wellenlänge von 660 nm verwendet werden. Zuerst wird α-Quinquethiophen optisch in einen Tₙ-Zustand überführt. Über einen Energietransfer können dann Photosensibilisatoren, die als Radikalbildner wirken, angeregt werden. Als Radikalbildner können beispielsweise 3,3'-Diazidodiphenylsulfon (DZDS) und 2,2-Dimethoxy-2-phenylacetophenon verwendet werden.

P-Phenylbenzoylderivate könnten mit einem Photosensibilisator, wie beispielsweise Benzophenon, in den T₁-Zustand angeregt werden. Beispiele für solche p-Phenylbenzoylderivate sind 4-Biphenylcarbonsäure, Methyl-4-Biphenylcarboxylat, Phenyl[1,1'-Biphenyl]-4-Carboxylat und 5-Phenyl[1,1'-Biphenyl]-4-Carbothioat. Durch eine weitere Anregung bei einer Wellenlänge von 420 nm kommt es zum Bindungsbruch, wodurch Radikale gebildet werden. Benzophenon kann hier bei einer Wellenlänge von 355 nm angeregt werden.

Ein ähnliches Verhalten wie bei den p-Phenylbenzoylderivaten kann bei Phenylphenacylderivaten beobachtet werden. Beispiele für solche p-Phenylbenzoylderivate sind 4-Phenylacetophenon, 2-Brom-4'-phenylacetophenon, 2-Chlor-4'-phenylacetophenon, 1-(4-Biphenyl)-2-Hydroxyethanon, 1-[1,1'-Biphenyl]-4-yl-2-Methoxyethanon, 1-Biphenyl-4-yl-2-Phenoxyethanon, 1-[1,1'-Biphenyl]-4-yl-2-Sulfanylethanon und 1-[1,1'-Biphenyl]-4-yl-2-Phenylsulfanylethanon. Mithilfe eines Photosensibilisators, wie beispielsweise Benzophenon, kann das Phenylphenacylderivat in den T₁-Zustand angeregt werden. Durch eine weitere Anregung bei einer Wellenlänge von 440 nm kommt es zum Bindungsbruch, wodurch Radikale gebildet werden. Benzophenon kann hier bei 355 nm angeregt werden.

Phenothiazin kann bei Absorption eines Photons einer ersten Wellenlänge von 308 nm in den T₁-Zustand angeregt werden. Durch eine weitere Anregung bei einer Wellenlänge von 480 nm kommt es zum Bindungsbruch, wodurch Radikale gebildet werden.

### 2) Verbindung mit einer photolabilen Schutzgruppe ("photomaskierte" Initiatoren)

Eine schrittweise Radikalbildung durch Absorption eines ersten Photons der ersten Wellenlänge λ₁ und eines zweiten Photons der zweiten Wellenlänge λ₂ kann auch unter Verwendung von photolabilen Schutzgruppen (engl. "caged") erreicht werden. Dabei wird ein Photoinitiator mit einer Schutzgruppe im Photolack bereitgestellt. Der Photoinitiator kann erst angeregt werden, nachdem die Schutzgruppe durch Bestrahlung abgetrennt wurde.

Ein Beispiel für eine Verbindung mit einer photolabilen Schutzgruppe ist Benzodioxin. Dieses zerfällt unter Bestrahlung mit einer ersten Wellenlänge von 320 nm. Als Reaktionsprodukt entsteht dabei unter anderem Benzophenon. Dieses kann wiederum durch Bestrahlung bei einer zweiten Wellenlänge von 350 nm in den Triplett-Grundzustand angeregt werden, wodurch eine Radikalbildung ausgelöst werden kann.

### 3) In-situ photosynthetisierter Initiator

Gemäß einer weiteren Ausführungsform können Radikale in einem zweistufigen Prozess durch *in-situ* Photosynthese eines Photoinitiators generiert werden. Dabei umfasst der Photolack Bestandteile, die ein oder mehrere Edukte zur Synthese eines Photoinitiators darstellen. Photoinduziert durch Bestrahlung mit einer ersten Wellenlänge λ₁ wird eine Reaktion gestartet, die diese Edukte zu einem Photoinitiator umsetzt. Durch Bestrahlen mit einer zweiten Wellenlänge λ₂ wird dann der synthetisierte Photoinitiator angeregt, so dass dieser ein Radikal bildet.

Bei dieser Radikalbildungsmethode sollte das mindestens eine Monomer des Photolacks inert gegenüber den Edukten und den Zwischenprodukten der Synthese des Photoinitiators sein.

Edukte für eine solche *in-situ* Photosynthese eines Photoinitiators können beispielsweise 2,5-Diphenyl-3,4-benzofuran oder Thioxanthon-Anthracen sein.

2,5-Diphenyl-3,4-benzofuran kann in einem ersten Schritt in 1,2-Dibenzoylbenzen konvertiert werden. Um diese Reaktion zu starten, kann Methylenblau als Photosensibilisator eingesetzt werden. Methylenblau kann mit Strahlung einer ersten Wellenlänge λ₁ von 632 nm angeregt werden, wodurch es 2,5-Diphenyl-3,4-benzofuran in den Triplett-Zustand bringen kann, welches sich daraufhin in 1,2-Dibenzoylbenzen umwandelt. Letzteres kann durch Bestrahlen bei einer zweiten Wellenlänge λ₂ von 365 nm angeregt werden.

In Gegenwart von Sauerstoff und bei Bestrahlen mit einer ersten Wellenlänge λ₁ von 450 nm reagiert Thioxanthon-Anthracen zu einem Thioxanthon-Anthracen-Endoperoxid. Dieses zerfällt durch Bestrahlung bei einer zweiten Wellenlänge λ₂ von 400 nm in zwei Radikale.

### 4) Photochromische Verbindung

Als "Photochromismus" wird erfindungsgemäß die Eigenschaft eines Stoffes bezeichnet, das Absorptionsverhalten unter Lichteinstrahlung zu verändern. Der Effekt kommt dadurch zustande, dass eine Verbindung eine reversible Umwandlung zwischen zwei Isomeren durchläuft.

Gemäß einer Ausführungsform kann die photochromische Eigenschaft in der vorliegenden Erfindung genutzt werden, indem eine Verbindung reversibel zwischen einem transparenten und einem absorbierenden Zustand geschaltet wird.

Beispiele für eine photochromische Verbindung sind 2-Methoxynaphthalin und Spiropyrane.

2-Methoxynaphthalin ist eine photochromische Verbindung, die im cis-Zustand eine Absorptionsbande bei der Wellenlänge 300 nm zeigt. Nach Absorption eines Photons der ersten Wellenlänge λ₁ kann die Verbindung in den trans-Zustand schalten und dabei Dimere bilden. Alternativ kann die Verbindung in einen Triplett-Zustand übergehen und als Photosensibilisator für Anregung von Triplett-Zuständen bei einer zweiten Wellenlänge λ₂ von 326 nm dienen.

Ein Beispiel für ein Spiropyran, das die obengenannten Eigenschaften erfüllt, ist 1,3,3-Trimethylindolino-6'-nitrobenzopyrylospiran. Dieses wird bei Bestrahlung mit einer ersten Wellenlänge λ₁ im blauen oder UV-Bereich zu Merocyanin isomerisiert. Merocyanin geht bei Absorption eines Photons einer zweiten Wellenlänge λ₂ im sichtbaren Bereich, zum Beispiel 532 nm, in eine reaktive Spezies über, die die Aushärtung des Photolacks herbeiführen kann. Die lichtinduzierte Isomerisierung von Spiropyran ist reversibel.

### 5) Quencher

Erfindungsgemäß wird unter "Quenching" (engl., "Fluoreszenzlöschung") ein Vorgang bezeichnet, bei dem ein Fluorophor seine Fluoreszenzintensität verliert. Dies passiert zum Beispiel, wenn ein Fluorophor, der in einem angeregten Zustand ist, seine Anregungsenergie mittels eines Energietransfers an ein anderes Molekül abgibt. Dieser Energietransfer kann etwa durch Stöße oder Dipol-Dipol-Wechselwirkungen zustande kommen. Die Dipol-Dipol-Fluoreszenzlöschung findet statt, wenn sich die spektrale Emissionsbande des Fluorophors und die Absorptionsbande des Quenchers überlagern. Für eine hohe Effizienz des Energietransfers darf der Abstand der Energieniveaus von Quencher und Fluorophor nicht groß sein. Bevorzugt ist der spektrale Abstand kleiner als 10 nm.

In der vorliegenden Erfindung kann der obengenannte Mechanismus genutzt werden, indem ein Photoinitiator, der mit einem Photon einer ersten Wellenlänge λ₁ angeregt wurde, aber noch nicht in ein Radikal zerfallen ist, durch eine Quencher-Verbindung abgeregt wird, wodurch die Radikalbildung unterdrückt wird. Wird die Quencher-Verbindung mittels Bestrahlung einer zweiten Wellenlänge λ₂ lokal "abgeschaltet", können Radikale durch den Photoinitiator gebildet werden.

### 6) pH-sensitiver Photoinitiator

In dieser Ausführungsform der vorliegenden Erfindung wird ausgenutzt, dass Photoinitiatoren häufig eine pH-abhängige spektrale Verschiebung ihrer Absorptionsbande aufweisen. Dabei kann der pH-Wert beispielsweise mit einem Photosäuregenerator lokal variiert werden. Dieser kann bei Bestrahlung mit einer ersten Wellenlänge λ₁ eine Säure bilden. Diese Säure verschiebt die Absorptionsbande eines Photoinitiators so, dass dieser Strahlung einer zweiten Wellenlänge λ₂ absorbieren kann. In Bereichen, in denen keine Säure durch Bestrahlung mit der ersten Wellenlänge λ₁ gebildet wurde, absorbiert der Photoinitiator weder Licht der Wellenlänge λ₁ noch λ₂.

In einer Ausführungsform umfasst das Photoinitiatorsystem ein α-Diketon oder eine photochromische Verbindung.

In den obengenannten Ansätzen 1) bis 6) werden keine virtuellen, kurzlebigen Energieniveaus von Molekülen besetzt. In diesem Zusammenhang bedeutet "kurzlebig" eine Lebensdauer kleiner als 1 ps. Aus diesem Grund werden keine Lichtquellen mit hohen Spitzenintensitäten benötigt. Im Gegensatz dazu wird in der Zwei-Photonen-Lithographie für die Absorption zweier Photonen ein virtuelles Zwischenniveau genutzt, was eine höhere Spitzenintensität eines Lasers erfordert.

Gemäß einer Ausführungsform des erfindungsgemäßen Verfahrens zur additiven Herstellung kann im Schritt ii) eine Ein-Photonen-Absorption durch das mindestens eine Photoinitiatorsystem erfolgen. Erfindungsgemäß wird unter einer "Ein-Photonen-Absorption" eine Absorption eines Photons durch ein Molekül bezeichnet. Des Weiteren bedeutet der Begriff "Zwei-Photonen-Absorption" die simultane Absorption zweier Photonen durch ein Molekül, wobei die Photonen innerhalb von wenigen Femtosekunden absorbiert werden. In der vorliegenden Erfindung können zwei Photonen zur Anregung von Zustand "G" zu Zustand "A" zu Zustand "R" (vgl. Figur 2) hingegen in einem Zeitintervall von wenigen Picosekunden bis zu wenigen Millisekunden absorbiert werden.

Für eine Ein-Photonen-Absorption ist im Gegensatz zur Zwei-Photonen-Absorption eine deutlich geringere Leistung pro Laserfokus notwendig. Durch die geringere Leistungsanforderung der Lichtquelle kann der technische Aufwand zur Durchführung des Verfahrens verringert werden.

In einer Ausführungsform des erfindungsgemäßen Verfahrens zur additiven Herstellung wird nach dem schrittweisen Aufbau der 3D-strukturierten Form ein Schritt des Auswaschens durchgeführt, bei dem nicht ausgehärtete Teile des Photolacks entfernt werden.

Ein zweiter Aspekt der Erfindung betrifft eine Vorrichtung zur additiven Herstellung einer 3D-strukturierten Form, ausgehend von einem flüssigen Photolack, umfassend eine erste Lichtquelle mit einer ersten Wellenlänge λ₁,
eine zweite Lichtquelle mit einer zweiten Wellenlänge λ₂, und
ein Substrat zum Bereitstellen des flüssigen Photolacks,
wobei λ₁ ≠ λ₂ und
die erste Lichtquelle und die zweite Lichtquelle auf das Substrat ausgerichtet sind, um den flüssigen Photolack an der Position auszuhärten, die von der ersten Lichtquelle und der zweiten Lichtquelle mit einem zeitlichen Abstand von kleiner als 1 ms bestrahlt wird.

Ein Beispiel der erfindungsgemäßen Vorrichtung zur additiven Herstellung ist in Figur 1 gezeigt.

Erfindungsgemäß ist unter einer "Vorrichtung zur additiven Herstellung" eine Vorrichtung zu verstehen, in der die 3D-strukturierte Form durch Aushärtung des flüssigen Photolacks schrittweise aufgebaut wird. Diese Vorrichtung zur additiven Herstellung ist zu unterscheiden von einer Vorrichtung zur subtraktiven Herstellung, bei der Material einer Form abgetragen wird.

Die in der Vorrichtung zur additiven Herstellung hergestellte 3D-strukturierte Form, die erste Lichtquelle mit der ersten Wellenlänge λ₁, die zweite Lichtquelle mit der zweiten Wellenlänge λ₂, das Substrat zum Bereitstellen des flüssigen Photolacks und der flüssige Photolack entsprechen der hergestellten 3D-strukturierten Form, der ersten Lichtquelle mit der ersten Wellenlänge λ₁, der zweiten Lichtquelle mit der zweiten Wellenlänge λ₂, dem Substrat und dem flüssigen Photolack des erfindungsgemäßen Verfahrens zur additiven Herstellung.

In einer Ausführungsform der Vorrichtung zur additiven Herstellung befindet sich das Substrat in einem Behälter, und das Substrat ist eingerichtet, eine in der Vorrichtung zur additiven Herstellung hergestellte 3D-strukturierte Form zu stützen. Dabei entspricht der Behälter dem Behälter des erfindungsgemäßen Verfahrens. Das Substrat kann eine Bühne sein oder auf einer Bühne angebracht sein, die der Bühne des erfindungsgemäßen Verfahrens zur additiven Herstellung entspricht.

Die vorliegende Erfindung erlaubt eine effiziente Parallelisierung der dreidimensionalen Aushärtung eines flüssigen Photolacks bei einer hohen Auflösung. Zudem können Kosten aufgrund der Verringerung des technischen Aufwands für die Implementierung der Erfindung im Vergleich zur herkömmlichen Zwei-Photonen-Lithographie gesenkt werden, da in der vorliegenden Erfindung die Anregung mittels stufenweiser Ein-Photonen-Absorption erfolgen kann.

Die Parallelisierung, welche die vorliegende Erfindung bereitstellt, gestattet es, 3D-Strukturierungen mithilfe von projektionsbasierten Methoden zu realisieren. Für eine solche projektionsbasierte Methode können Mikrospiegelaktoren verwendet werden, die eine kurze Schaltzeit von nur einigen Mikrosekunden aufweisen. Daher kann eine einzelne Ebene des flüssigen Photolacks innerhalb von Mikrosekunden bestrahlt und ausgehärtet werden. Im Gegensatz dazu werden in der herkömmlichen Zwei-Photonen-Lithographie häufig galvanometrisch angetriebene Spiegel eingesetzt, welche typischerweise einige Millisekunden benötigen, um eine Ebene vollständig zu bestrahlen.

Im Vergleich zu typischen stereolithographischen Vorrichtungen verbessert sich die Auflösung axial zu der Projektion der herzustellenden 3D-strukturierten Form in der vorliegenden Erfindung. Für herkömmliche Stereolithographiesysteme sind minimale axiale Strukturgrößen von bis zu 10 µm möglich. Im Gegensatz dazu ermöglicht die vorliegende Erfindung eine noch feinere Strukturierung, welche sogar unterhalb der Größe der Wellenlänge der verwendeten Lichtquellen liegt.

Die Figuren zeigen:
Figur 1 zeigt ein Beispiel des erfindungsgemäßen Verfahrens zur additiven Herstellung und der erfindungsgemäßen Vorrichtung zur additiven Herstellung.
Figur 2 zeigt eine schemenhafte Darstellung der Energieniveaus des Photoinitiatorsystems.
Figur 3 zeigt eine schematische Darstellung des nicht erfindungsgemäßen Aufbaus zur Charakterisierung eines Photolacks mit exemplarischen Lasern.

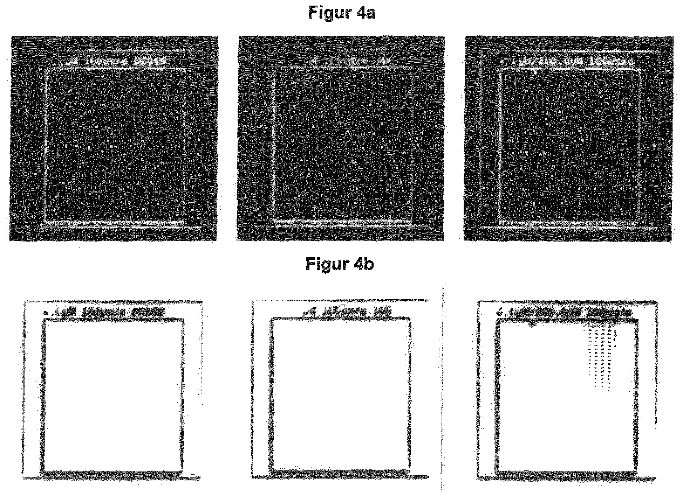

Figur 4a zeigt Mikroskopaufnahmen der durchgeführten Experimente mit dem Photolack 1. Entlang der horizontalen Achse wurde die z-Koordinate der Fokusebene variiert, entlang der vertikalen Achse die Intensität eines Lasers. Links: Der Laser bei 640 nm wurde geblockt, die Intensität des 440 nm-Lasers wurde von 0 bis 130 W/cm² variiert. Mitte: der Laser bei 440 nm wurde geblockt, die Intensität des 640 nm-Lasers wurde von 0 bis 690 W/cm² variiert. Rechts: Der Laser bei 440 nm wurde bei konstant 130 W/cm² betrieben. Die Intensität des 640 nm-Lasers wurde wie zuvor variiert. Figur 4b zeigt die entsprechenden farbinvertierten Mikroskopaufnahmen.

Die nachstehenden Beispiele dienen als weitere Erläuterungen der vorliegenden Erfindung, ohne darauf beschränkt zu sein.

Es wurden drei Photolacke untersucht. Die Photolacke setzen sich wie in Tabelle 1 angegeben zusammen.

| Photolack | Monomer | Photoinitiatorsystem |
|---|---|---|
| 1 | PETA | Diacetyl |
| | 99 Gew.-% | 1 Gew.-% |
| 2 | PETA | 1,3,3-Trimethylindolino-6'-nitrobenzopyrylospiran |
| | 99 Gew.-% | 1 Gew.-% |
| 3 | PETA | Benzil |
| | 99 Gew.-% | 1 Gew.-% |

| | | |
|---|---|---|
| Pentaerythritoltriacrylat (PETA): CAS 3524-68-3 Diacetyl: CAS 431-03-8 1,3,3-Trimethylindolino-6'-nitrobenzopyrylospiran: CAS 1498-88-0 Benzil: CAS 134-81-6 | | |

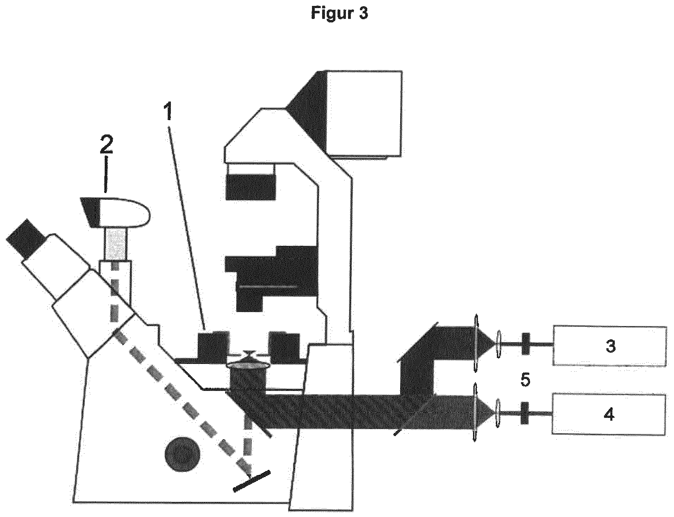

Der Aufbau ist in Figur 3 schematisch dargestellt.

Als Lichtquellen für Photolack 1 wurde
- ein Dauerstrichlaser mit einer Wellenlänge von 440 nm, 3 in Figur 3, und
- ein Dauerstrichlaser mit einer Wellenlänge von 640 nm, 4 in Figur 3,
   gewählt. Für Photolack 2 und Photolack 3 wurde
- ein gepulster Laser mit einer Wellenlänge von 405 nm mit einer Pulsdauer von 200 fs und einer Repetitionsrate von 80 MHz und
- ein Laser mit einer Wellenlänge von 532 nm im Dauerstrichbetrieb
   gewählt. Die durchschnittliche Intensität der jeweiligen Laser wurde an das jeweilige Photoinitiatorsystem angepasst.

Für Photolack 1 wurde die Intensität im Fokus des Lasers mit der Wellenlänge von 440 nm auf maximal 130 W/cm² gesetzt. Die Intensität des Lasers mit der Wellenlänge von 640 nm betrug maximal 690 W/cm².

Für Photolack 2 wurde die Intensität des Lasers mit der Wellenlänge von 405 nm auf maximal 260 W/cm² gesetzt. Die Intensität des Lasers mit der Wellenlänge von 532 nm betrug maximal 96 kW/cm².

Für Photolack 3 wurde die Intensität des Lasers mit der Wellenlänge von 405 nm auf maximal 16 W/cm² gesetzt. Die Intensität des Lasers mit der Wellenlänge von 532 nm betrug maximal 48 kW/cm².

Für die Intensitätsmodulation wurde ein akustooptischer Modulator (5 in Figur 3) verwendet. Die Leistungen wurden jeweils in der Ebene der Mikroskopobjektivpupille gemessen und anhand einer Messung der Breite des fokussierten Strahls in Intensitäten umgerechnet.

Beide Laserstrahlen wurden vergrößert, mithilfe eines Strahlteilers überlagert und in ein Mikroskopobjektiv (100x, NA 1,4, Ölimmersion) geführt. Die Laser wurden durch ein Mikroskopdeckglas (170 µm Dicke) in einen Tropfen aus dem jeweiligen Photolack fokussiert. Das Deckglas wurde mittels einer Piezobühne (1 in Figur 3) räumlich bewegt. Mithilfe einer Digitalkamera (2 in Figur 3) konnte der Aushärtungsvorgang in der Fokusebene in Echtzeit verfolgt werden.

Es wurden drei Messreihen durchgeführt.
1. Messreihe:
   In der 1. Messreihe wurde die Intensität des 440 nm-Lasers in einem Bereich von 0 bis 130 W/cm² variiert und der 640 nm-Laser geblockt. Die Intensität des 440 nm-Lasers wurde graduell erhöht. Der Photolack härtet in diesem Bereich nicht aus (vgl. Figur 4a und 4b links).
2. Messreihe:
   In einer 2. Messreihe wurde der Strahl des 440 nm-Lasers geblockt und die Intensität des 640 nm-Lasers graduell in einem Bereich von 0 bis 690 W/cm² erhöht. Der Photolack härtet in diesem Bereich nicht aus (vgl. Figur 4a und 4b Mitte).
3. Messreihe:
   In der 3. Messreihe wurde die Intensität des 640 nm-Lasers linear bis 690 W/cm² erhöht, während der 440 nm-Laser konstant bei maximaler Intensität (130 W/cm²) betrieben wurde. Es zeigte sich, dass das Photolack 1 bei einem Schwellwert von I_{1A} = 185 W/cm² aushärtet (vgl. Figur 4a und 4b rechts).

Mikroskopaufnahmen der drei Messreihen für Photolack 1 sind in Figur 4a und 4b gezeigt. Die Intensität wurde in den Aufnahmen entlang der Vertikalen variiert. Dabei entspricht das untere Ende der Aufnahme einer Intensität von 0 W/cm² und das obere Ende dem jeweiligen Maximalwert.

Experimente für den Photolack 2 und Photolack 3 mit den entsprechenden Lasern ergeben ähnliche Resultate (nicht gezeigt).

Es ist zu erkennen, dass die Schwelle zur Aushärtung des Photolacks erreicht wird, wenn gleichzeitig mit dem 640 nm-Laser und dem 440 nm-Laser bestrahlt wird, wie für die 3. Messreihe in Figur 4a und 4b gezeigt werden konnte.

In der 1. Messreihe und der 2. Messreihe zeigte sich im dargestellten Bereich keine Aushärtung des Photolacks.

### Bezugszeichenliste

- 1: Piezobühne
- 2: Digitalkamera
- 3: 440 nm-Laser (Dauerstrich)
- 4: 640 nm-Laser (Dauerstrich)
- 5: Akustooptischer Modulator

## Patentansprüche

1. Verfahren zur additiven Herstellung einer 3D-strukturierten Form, umfassend die Schritte in der folgenden Reihenfolge:
i) Bereitstellen eines flüssigen Photolacks, umfassend mindestens ein Monomer und mindestens ein Photoinitiatorsystem,
ii) Bestrahlen des flüssigen Photolacks mit einer ersten Lichtquelle bei einer ersten Wellenlänge λ₁ und mit einer zweiten Lichtquelle bei einer zweiten Wellenlänge λ₂,
wobei λ₁ ≠ λ₂ und die Bestrahlungsrichtung der ersten Lichtquelle verschieden von der Bestrahlungsrichtung der zweiten Lichtquelle ist,
wobei eine Aushärtung des flüssigen Photolacks zu der 3D-strukturierten Form nur an der Position erfolgt, die von der ersten Lichtquelle und der zweiten Lichtquelle mit einem zeitlichen Abstand von kleiner als 1 ms bestrahlt wird,
**dadurch gekennzeichnet, dass** das
Photoinitiatorsystem eine Verbindung umfasst, welche nach der Absorption eines ersten Photons mit der ersten Wellenlänge λ₁ der ersten Lichtquelle in einen dormanten Zwischenzustand übergeht, der keine aushärtende Eigenschaft besitzt, und in Folge der Absorption eines zweiten Photons mit der zweiten Wellenlänge λ₂ ≠ λ₁ der zweiten Lichtquelle ein Radikal bildet, dass das
mindestens eine Monomer aushärten kann, wobei der dormante Zwischenzustand wieder in den Grundzustand zurückkehrt, falls kein zweites Photon der zweiten Wellenlänge λ₂ von dem Photoinitiatorsystem absorbiert wird.

2. Verfahren nach Anspruch 1,
wobei im Schritt ii) die herzustellende 3D-strukturierte Form in mindestens eine der Fokusebenen der ersten Lichtquelle und der zweiten Lichtquelle abgebildet wird.

3. Verfahren nach Anspruch 1 oder 2,
wobei der flüssige Photolack in dem Schritt i) in einem Behälter bereitgestellt wird, wobei sich in diesem Behälter ein Substrat befindet, das die hergestellte 3D-strukturierte Form stützt.

4. Verfahren nach einem der Ansprüche 1 bis 3,
wobei die erste Lichtquelle und die zweite Lichtquelle Laser sind.

5. Verfahren nach Anspruch 4,
wobei mindestens einer der Laser ein gepulster Laser ist.

6. Vorrichtung zur additiven Herstellung einer 3D-strukturierten Form, ausgehend von einem flüssigen Photolack, umfassend
einen flüssigen Photolack, umfassend mindestens ein Monomer und mindestens ein Photoinitiatorsystem,
eine erste Lichtquelle (3) mit einer ersten Wellenlänge λ₁,
eine zweite Lichtquelle (4) mit einer zweiten Wellenlänge λ₂, und
ein Substrat (1) zum Bereitstellen des flüssigen Photolacks,
wobei λ₁ ≠ λ₂ und die Bestrahlungsrichtung der ersten Lichtquelle verschieden von der Bestrahlungsrichtung der zweiten Lichtquelle ist,
wobei die erste Lichtquelle und die zweite Lichtquelle auf das Substrat ausgerichtet sind, um den flüssigen Photolack an der Position auszuhärten, die von der ersten Lichtquelle und der zweiten Lichtquelle mit einem zeitlichen Abstand von kleiner als 1 ms bestrahlt wird,
**dadurch gekennzeichnet, dass** das
Photoinitiatorsystem eine Verbindung umfasst, welche nach der Absorption eines ersten Photons mit der ersten Wellenlänge λ₁ der ersten Lichtquelle in einen dormanten Zwischenzustand übergeht, der keine aushärtende Eigenschaft besitzt, und in Folge der Absorption eines zweiten Photons mit der zweiten Wellenlänge λ₂ ≠ λ₁ der zweiten Lichtquelle ein Radikal bildet, dass das mindestens eine Monomer aushärten kann, wobei der dormante Zwischenzustand wieder in den Grundzustand zurückkehrt, falls kein zweites Photon der zweiten Wellenlänge λ₂ von dem Photoinitiatorsystem absorbiert wird.

7. Vorrichtung nach Anspruch 6, wobei sich das Substrat in einem Behälter befindet und das Substrat eingerichtet ist, eine in der Vorrichtung zur additiven Herstellung hergestellte 3D-strukturierte Form zu stützen.

8. Vorrichtung nach Anspruch 6 oder 7, wobei die erste Lichtquelle und die zweite Lichtquelle Laser sind.

9. Vorrichtung nach Anspruch 8,
wobei mindestens einer der Laser ein gepulster Laser ist.

## Claims

1. A method for additive manufacturing of a 3D-structured form, comprising these steps in the following sequence:
i) providing a liquid photoresist, comprising at least one monomer and at least one photoinitiator system,
ii) irradiating the liquid photoresist with a first light source at a first
wavelength λ₁ and with a second light source at a second wavelength λ₂, wherein λ₁ ≠ λ₂ and the direction of irradiation of the first light source is different from the direction of irradiation of the second light source,
wherein hardening of the liquid photoresist to form the 3D-structured form takes place only at the position which is irradiated by the first light source and the second light source with a time interval of less than 1 ms,
**characterized in that** the photoinitiator system comprises a compound which, after the absorption of a first photon with the first wavelength λ₁ of the first light source, passes into a dormant intermediate state which has no curing property, and as a result of the absorption of a second photon with the second wavelength λ₂ ≠ λ₁ of the second light source forms a radical that can cure the at least one monomer, the dormant intermediate state returning to the ground state if no second photon of the second wavelength λ₂ is absorbed by the photoinitiator system.

2. The method according to claim 1,
wherein in step ii) the 3D-structured form to be produced is imaged into at least one of the focal planes of the first light source and of the second light source.

3. The method according to claim 1 or 2,
wherein the liquid photoresist in step i) is provided in a container, wherein a substrate which supports the fabricated 3D-structured form is located in this container.

4. The method according to any one of claims 1 to 3,
wherein the first light source and the second light source are lasers.

5. The method according to claim 4,
wherein at least one of the lasers is a pulsed laser.

6. A device for additive manufacturing of a 3D-structured form, starting from a liquid photoresist, comprising
a liquid photoresist, comprising at least one monomer and at least one photoinitiator system,
a first light source (3) with a first wavelength λ₁,
a second light source (4) with a second wavelength λ₂, and
a substrate (1) for providing the liquid photoresist,
wherein λ₁ ≠ λ₂ and the direction of irradiation of the first light source is different from the direction of irradiation of the second light source, wherein the first light source and the second light source are oriented toward the substrate in order to harden the liquid photoresist at the position which is irradiated by the first light source and the second light source with a time interval of less than 1 ms,
**characterized in that** the photoinitiator system comprises a compound which, after the absorption of a first photon with the first wavelength λ₁ of the first light source, passes into a dormant intermediate state which has no curing property, and as a result of the absorption of a second photon with the second wavelength λ₂ ≠ λ₁ of the second light source forms a radical that can cure the at least one monomer, the dormant intermediate state returning to the ground state if no second photon of the second wavelength λ₂ is absorbed by the photoinitiator system.

7. The device according to claim 6, wherein the substrate is located in a container and the substrate is configured to support a 3D-structured form fabricated in the device for additive manufacturing.

8. The device according to claim 6 or 7, wherein the first light source and the second light source are lasers.

9. The device according to claim 8,
wherein at least one of the lasers is a pulsed laser.

## Revendications

1. Procédé de fabrication additive d'un moule à structuration tridimensionnelle, comprenant les étapes dans l'ordre suivant :
i) mise à disposition d'une résine photosensible liquide, comprenant au moins un monomère et au moins un système de photo-initiateur,
ii) irradiation de la résine photosensible liquide avec une première source lumineuse à une première longueur d'onde λ₁ et avec une seconde source lumineuse à une seconde longueur d'onde λ₂,
dans lequel λ₁ ≠ λ₂ et la direction d'irradiation de la première source lumineuse est différente de la direction d'irradiation de la seconde source lumineuse,
dans lequel un durcissement de la résine photosensible liquide en le moule à structuration tridimensionnelle n'a lieu qu'à la position qui est irradiée par la première source lumineuse et la seconde source lumineuse avec un écart temporel inférieur à 1 ms,
**caractérisé en ce que** le système de photo-initiateur comprend un composé qui passe après l'absorption d'un premier photon avec la première longueur d'onde λ₁ de la première source lumineuse à un état intermédiaire dormant, qui ne possède aucune propriété durcissante, et forme à la suite de l'absorption d'un second photon avec la seconde longueur d'onde λ₂ ≠ λ₁ de la seconde source lumineuse un radical, que l'au moins un monomère peut durcir, dans lequel l'état intermédiaire dormant retourne de nouveau à l'état de base au cas où aucun second photon de la seconde longueur d'onde λ₂ n'est absorbé par le système de photo-initiateur.

2. Procédé selon la revendication 1,
dans lequel à l'étape ii), le moule à structuration tridimensionnelle à fabriquer est reproduit dans au moins un des plans focaux de la première source lumineuse et de la seconde source lumineuse.

3. Procédé selon la revendication 1 ou 2,
dans lequel la résine photosensible liquide est mise à disposition à l'étape i) dans un récipient, dans lequel un substrat qui soutient le moule à structuration tridimensionnelle fabriqué se trouve dans ce récipient.

4. Procédé selon une des revendications 1 à 3,
dans lequel la première source lumineuse et la seconde source lumineuse sont des laser.

5. Procédé selon la revendication 4,
dans lequel au moins un des laser est un laser pulsé.

6. Dispositif de fabrication additive d'un moule à structuration tridimensionnelle, à partir d'une résine photosensible liquide, comprenant
une résine photosensible liquide, comprenant au moins un monomère et au moins un système de photo-initiateur,
une première source lumineuse (3) avec une première longueur d'onde λ₁,
une seconde source lumineuse (4) avec une seconde longueur d'onde λ₂, et
un substrat (1) pour la mise à disposition de la résine photosensible liquide,
dans lequel λ₁ ≠ λ₂ et la direction d'irradiation de la première source lumineuse est différente de la direction d'irradiation de la seconde source lumineuse,
dans lequel la première source lumineuse et la seconde source lumineuse sont orientées sur le substrat pour durcir la résine photosensible liquide à la position qui est irradiée par la première source lumineuse et la seconde source lumineuse avec un écart temporel inférieur à 1 ms,
**caractérisé en ce que** le système de photo-initiateur comprend un composé qui passe après l'absorption d'un premier photon avec la première longueur d'onde λ₁ de la première source lumineuse à un état intermédiaire dormant, qui ne possède aucune propriété durcissante, et forme à la suite de l'absorption d'un second photon avec la seconde longueur d'onde λ₂ ≠ λ₁ de la seconde source lumineuse un radical, que l'au moins un monomère peut durcir, dans lequel l'état intermédiaire dormant retourne de nouveau à l'état de base au cas où aucun second photon de la seconde longueur d'onde λ₂ n'est absorbé par le système de photo-initiateur.

7. Dispositif selon la revendication 6, dans lequel le substrat se trouve dans un récipient et le substrat est configuré pour soutenir un moule à structuration tridimensionnelle fabriqué dans le dispositif de fabrication additive.

8. Dispositif selon la revendication 6 ou 7, dans lequel la première source lumineuse et la seconde source lumineuse sont des laser.

9. Dispositif selon la revendication 8,
dans lequel au moins un des laser est un laser pulsé.
